(19)

Europäisches
Patentamt
European
Patent Office
Office européen
des brevets

(11) **EP 3 605 624 A1**

(12) **EUROPEAN PATENT APPLICATION**
published in accordance with Art. 153(4) EPC

(43) Date of publication:
**05.02.2020 Bulletin 2020/06**

(51) Int Cl.:
*H01L 35/30* (2006.01)       *G01K 3/08* (2006.01)
*H01L 35/10* (2006.01)       *H01L 35/32* (2006.01)
*H02N 11/00* (2006.01)

(21) Application number: **18771452.2**

(22) Date of filing: **22.03.2018**

(86) International application number:
**PCT/JP2018/011448**

(87) International publication number:
**WO 2018/174173 (27.09.2018 Gazette 2018/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **24.03.2017 JP 2017058694**

(71) Applicant: **Yamaha Corporation
Hamamatsu-shi, Shizuoka 430-8650 (JP)**

(72) Inventor: **HAYASHI Takahiro
Hamamatsu-shi
Shizuoka 430-8650 (JP)**

(74) Representative: **Hoffmann Eitle
Patent- und Rechtsanwälte PartmbB
Arabellastraße 30
81925 München (DE)**

(54) **THERMOELECTRIC POWER GENERATING MODULE, THERMOELECTRIC POWER GENERATING DEVICE USING SAID THERMOELECTRIC POWER GENERATING MODULE, AND TEMPERATURE MEASURING METHOD**

(57)     A thermoelectric power generating module includes a high-temperature-side substrate, a low-temperature-side substrate, a plurality of thermoelectric element pairs, a plurality of high-temperature-side electrodes, a plurality of low-temperature-side electrodes, and at least one pair of extraction electrodes. The low-temperature-side substrate faces opposite the high-temperature-side substrate. The plurality of thermoelectric element pairs are configured from mutually adjacent P-type elements and N-type elements, and are arrayed between the high-temperature-side substrate and the low-temperature-side substrate. The plurality of high-temperature-side electrodes are provided on the high-temperature-side substrate, and connect the P-type elements and the N-type elements that constitute the respective plurality of thermoelectric element pairs. The plurality of low-temperature-side electrodes are provided on the low-temperature-side substrate, and by connecting the P-type elements and the N-type elements, connect the plurality of thermoelectric element pairs in series. At least one of the pairs of extraction electrodes is extracted from the plurality of low-temperature-side electrodes so as to be able to measure the thermo-electromotive force of a portion of the plurality of thermoelectric element pairs.

FIG. 2

## Description

TECHNICAL FIELD

The present invention relates to a thermoelectric power generating module, a thermoelectric power generating device using said thermoelectric power generating module, and a temperature measuring method.
Priority is claimed on Japanese Patent Application No. 2017-58694, filed March 24, 2017, the content of which is incorporated herein by reference.

BACKGROUND ART

Thermoelectric power generation is drawing attention as a clean energy source that can convert waste heat from automobiles and factories into electrical energy. A thermoelectric power generating module used for thermoelectric power generation has a configuration in which thermoelectric elements arranged in a predetermined pattern are sandwiched between a high-temperature-side substrate and a low-temperature-side substrate, and generates electrical energy in accordance with the temperature difference between the high-temperature-side substrate and the low-temperature-side substrate.
In a thermoelectric power generating module, when the temperature of the high-temperature-side substrate becomes too high, failure easily occurs. For example, thermoelectric elements connected to the high-temperature-side substrate are susceptible to damage by excessive temperature rise. In addition, when the high-temperature-side substrate thermally expands with the temperature rise, breakage may occur due to shear stress being applied to the thermoelectric elements.
In contrast, Patent Document 1 discloses a technology capable of temperature management of a thermoelectric cooling module. In this technology, a temperature measuring element is provided on the substrate constituting the cooling surface of the thermoelectric cooling module, outside the region where the heat generating body to be cooled is disposed. Thereby, the temperature on the substrate of the thermoelectric cooling module can be ascertained.

Prior Art Documents

Patent Documents

[Patent Document 1] Japanese Unexamined Patent Application No. 2009-94130

DISCLOSURE OF THE INVENTION

Problems to be Solved by the Invention

In the thermoelectric cooling module, in order to cool the heat generating body effectively, it is common to make the substrate constituting the cooling surface large with respect to the heat generating body. For this reason, in the thermoelectric cooling module described in Patent Document 1, a region in which a heat generating body is not disposed is formed on the substrate, and the temperature measuring element is provided in this region.
On the other hand, in the thermoelectric power generating module, in order to obtain high heat collection efficiency in the high-temperature-side substrate, it is preferable that a heat collector be connected over the entire region of the high-temperature-side substrate. For this reason, in the thermoelectric power generating module, it is difficult to secure a region for providing the temperature measuring element on the high-temperature-side substrate without impairing the heat collection efficiency.
In view of the above circumstances, the object of the present invention is to provide a thermoelectric power generating module capable of preventing failure due to overheating, a thermoelectric power generating device using the thermoelectric power generating module, and a temperature measuring method.

Means for Solving the Problems

In order to achieve the aforementioned object, a thermoelectric power generating module according to one aspect of the present invention is provided with a high-temperature-side substrate, a low-temperature-side substrate, a plurality of thermoelectric element pairs, a plurality of high-temperature-side electrodes, a plurality of low-temperature-side electrodes, and at least one pair of extraction electrodes.
The low-temperature-side substrate faces opposite the high-temperature-side substrate.
The plurality of thermoelectric element pairs are configured from mutually adjacent P-type elements and N-type elements, and are arrayed between the high-temperature-side substrate and the low-temperature-side substrate.
The plurality of high-temperature-side electrodes are provided on the high-temperature-side substrate, and connect the pairs of the P-type elements and the N-type elements that constitute the respective plurality of thermoelectric element pairs.
The plurality of low-temperature-side electrodes are provided on the low-temperature-side substrate, and by connecting the P-type elements and the N-type elements, connect the plurality of thermoelectric element pairs.
A pair of first extraction electrodes are connected to both ends of the plurality of low-temperature-side electrodes that connect in series the plurality of thermoelectric element pairs. A pair of second extraction electrodes are connected to a portion of the thermoelectric element pairs among the plurality of thermoelectric element pairs via the low-temperature-side electrodes.

In this configuration, by measuring a voltage between the pair of second extraction electrodes, a thermo-electromotive force generated by the thermoelectric element pairs connected to the pair of extraction electrodes can be obtained. The temperature difference between the low-temperature-side substrate and the high-temperature-side substrate in the region where the thermoelectric element pairs are disposed can be calculated by this thermo-electromotive force. Accordingly, the temperature of the high-temperature-side substrate in the region can be calculated by detecting the temperature of the low-temperature-side substrate using a publicly known method.

That is, in this configuration, the temperature of a specific region in the high-temperature-side substrate can be ascertained without direct measurement.

The pair of second extraction electrodes may be disposed on the low-temperature-side substrate to the outside the opposing region of the high-temperature-side substrate.

The pair of second extraction electrodes may be extracted from the low-temperature-side electrodes disposed on a heat source side among the plurality of low-temperature-side electrodes.

In this configuration, it is possible to ascertain the temperature of the region that easily overheats in the high-temperature substrate of the thermoelectric power generating module.

A thermoelectric power generating device according to one aspect of the present invention is provided with the thermoelectric power generating module and a voltage measuring portion.

The voltage measuring portion measures a voltage between the pair of second extraction electrodes.

The thermoelectric power generating device may be further provided with a temperature detecting portion that detects a temperature of the low-temperature-side substrate.

A temperature measuring method according to one aspect of the present invention measures a temperature of the high-temperature side substrate of the thermoelectric power generating module.

A voltage between at least one thermoelectric element pair among the plurality of thermoelectric element pairs is measured.

Next, a temperature difference between the high-temperature-side substrate and the low-temperature-side substrate is calculated from the voltage.

Next, the temperature of the high-temperature-side substrate is calculated using the temperature difference.

In the temperature measuring method, electrical resistance between at least one thermoelectric element pair among the plurality of thermoelectric element pairs may be measured, the average temperature between the high-temperature-side substrate and the low-temperature-side substrate may be calculated from the electrical resistance, and the temperature of the high-temperature-side substrate may be calculated using the temperature difference and the average temperature.

BRIEF DESCRIPTION OF THE DRAWINGS

FIG. 1 is a perspective view showing the thermoelectric power generating device according to one embodiment of the present invention.
FIG. 2 is an exploded perspective view of the thermoelectric power generating module used in the thermoelectric power generating device.
FIG. 3 is a plan view sowing the configuration of the thermoelectric power generating device.
FIG. 4 is a cross-sectional view taken along line A-A' of FIG. 1 of the thermoelectric power generating device.
FIG. 5 is a plan view showing a first modification of the thermoelectric power generating module in the embodiment.
FIG. 6 is a plan view showing a second modification of the thermoelectric power generating module in the embodiment.
FIG. 7 is a plan view showing a third modification of the thermoelectric power generating module in the embodiment.
FIG. 8 is a plan view showing a fourth modification of the thermoelectric power generating module in the embodiment.
FIG. 9 is a plan view showing a fifth modification of the thermoelectric power generating module in the embodiment.

EMBODIMENTS FOR CARRYING OUT THE INVENTION

Embodiments of the present invention will now be described in detail with reference to the drawings. Note that each drawing is schematically illustrated for convenience of explanation, and the aspect of each structure shown by each drawing may not be exact. Further, in the drawings, X axis, Y axis, and Z axis which are mutually orthogonal to each other are shown as appropriate. The X-axis, Y-axis and Z-axis are common in all the figures.

1. Outline of thermoelectric power generating device 100

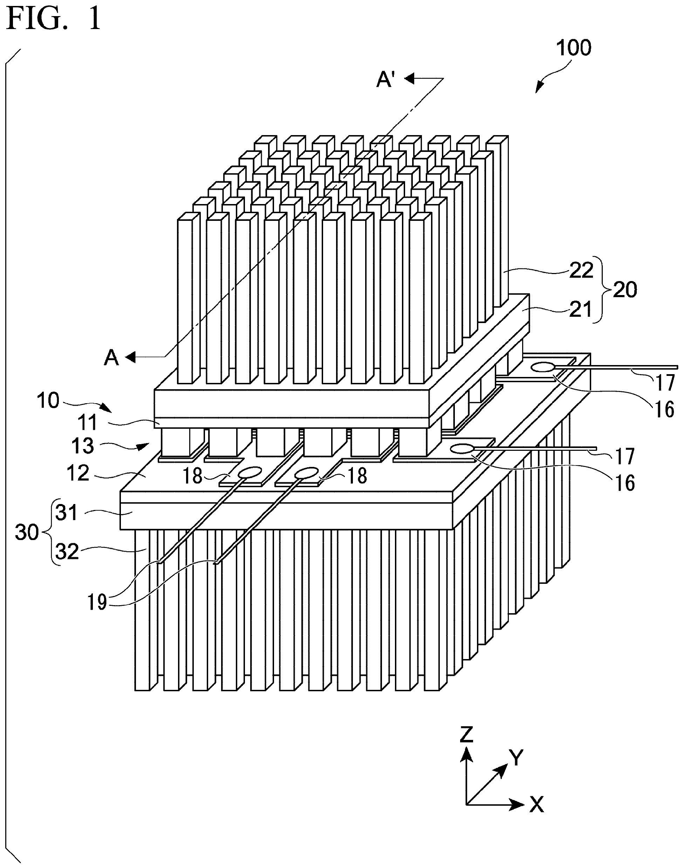

FIG. 1 is a perspective view of a thermoelectric power generating device 100 according to one embodiment of the present invention. The thermoelectric power generating device 100 is provided with a thermoelectric power generating module 10, a heat collector 20, and a radiator 30. The thermoelectric power generating module 10 has a flat plate shape extending along the XY plane, and is sandwiched by the heat collector 20 and the radiator 30 in the Z-axis direction.

The thermoelectric power generating module 10 has a high-temperature-side substrate 11, a low-temperature-side substrate 12, and a plurality of thermoelectric element pairs 13. The plurality of thermoelectric element pairs 13 are sandwiched in the Z-axis direction by the high-temperature-side substrate 11 and the low-temperature-side substrate 12 extending along the XY plane. The low-temperature-side substrate 12 on the lower side in the Z-axis direction has larger dimensions in the X-axis and Y-axis directions than the high-temperature-side substrate 11 on the upper side in the Z-axis direction.

The heat collector 20 is connected to the upper surface of the high-temperature-side substrate 11 in the Z axis direction, and the radiator 30 is connected to the lower surface of the low-temperature-side substrate 12 in the Z axis direction. That is, in the thermoelectric power generating module 10, the high-temperature-side substrate 11 receives a supply of heat from the heat collector 20, and heat of the low-temperature-side substrate 12 is dissipated by the radiator 30.

As a result, a temperature difference occurs between the high-temperature-side substrate 11 and the low-temperature-side substrate 12 of the thermoelectric power generating module 10. In the thermoelectric power generating module 10, electrical energy corresponding to the temperature difference between the high-temperature-side substrate 11 and the low-temperature-side substrate 12 is generated by the action of the plurality of thermoelectric element pairs 13. Details of the thermoelectric power generating module 10 will be described later.

The heat collector 20 has a heat diffusion plate 21 connected to the high-temperature-side substrate 11 of the thermoelectric power generating module 10 and heat collecting fins 22 arrayed on the upper surface of the heat diffusion plate 21 in the Z-axis direction. Each heat collecting fin 22 has a bar shape extending in the Z-axis direction. The cross-sectional shape perpendicular to the Z axis of each heat collecting fin 22 is a rectangular shape.

The radiator 30 has a heat diffusion plate 31 connected to the low-temperature-side substrate 12 of the thermoelectric power generating module 10 and heat dissipating fins 32 arrayed on the lower surface of the heat diffusion plate 31 in the Z-axis direction. Each heat dissipating fin 32 has a bar shape extending in the Z-axis direction. The cross-sectional shape perpendicular to the Z axis of each heat dissipating fin 32 is a rectangular shape.

The heat collector 20 and the radiator 30 are formed of a metal material having high thermal conductivity, for example, stainless steel having high heat resistance. However, the material forming the heat collector 20 and the radiator 30 may be other than stainless steel, and may be, for example, copper or aluminum. Furthermore, a surface treatment such as plating may be applied to the heat collector 20 and the radiator 30.

Various designs of the heat collector 20 and the radiator 30 are possible. For example, the lengths in the Z-axis direction of the heat collecting fins 22 and the heat dissipating fins 32 and the intervals thereof in the X-axis and Y-axis directions can be designed according to the required performance and the like. Moreover, the cross-sectional shape perpendicular to the Z axis of the heat collecting fins 22 and the heat dissipating fins 32 can be arbitrarily determined, and may also have a polygonal shape, a circular shape, and the like.

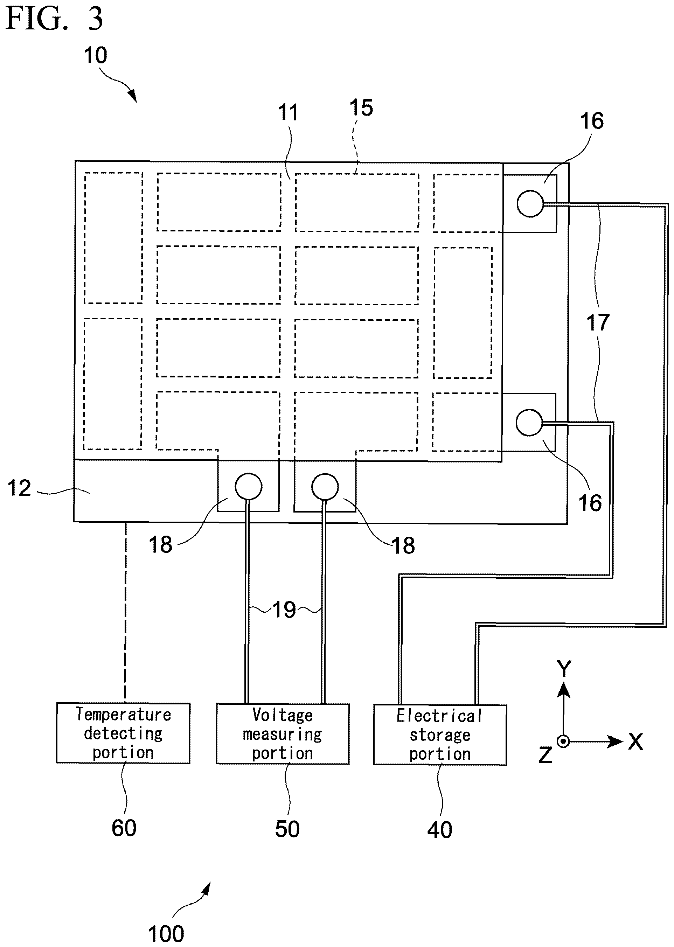

The thermoelectric power generating device 100 is further provided with an electrical storage portion 40, a voltage measuring portion 50, and a temperature detecting portion 60 (see FIG. 3 described later). The electrical storage portion 40 is configured as a secondary battery having a function of storing electrical energy generated by the thermoelectric power generating module 10. The voltage measuring portion 50 and the temperature detecting portion 60 will be described later.

2. Constitution of thermoelectric power generating module 10

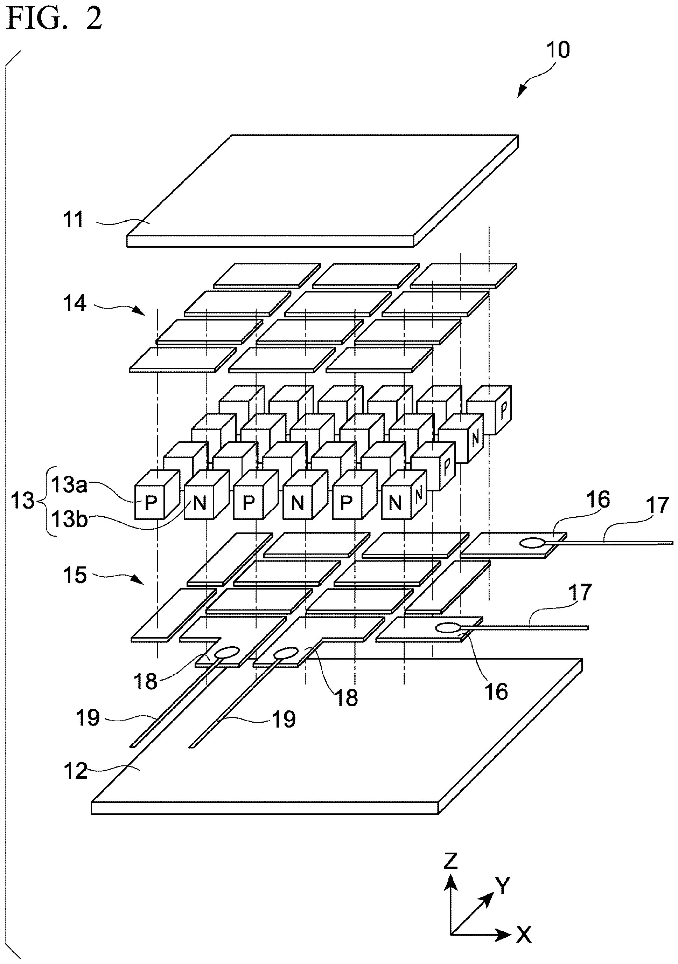

FIG. 2 is an exploded perspective view of the thermoelectric power generating module 10. The thermoelectric power generating module 10 further includes a plurality of high-temperature-side electrodes 14 and a plurality of low-temperature-side electrodes 15 in addition to the above constitution. Each thermoelectric element pair 13 is constituted by a P-type element 13a and an N-type element 13b adjacent to each other in the X-axis or Y-axis direction.

The P-type element 13a is formed of a P-type thermoelectric material, and the N-type element 13b is formed of an N-type thermoelectric material. As a thermoelectric material, for example, a bismuth-tellurium compound, a silicide compound, a half-Heusler compound, a lead-tellurium compound, a silicon-germanium compound, a skutterudite compound, a tetrahedrite compound, a korucite compound and the like can be used.

The high-temperature-side substrate 11 and the low-temperature-side substrate 12 are preferably formed of aluminum nitride, which has excellent heat resistance and thermal conductivity. However, the material for forming the high-temperature-side substrate 11 and the low-temperature-side substrate 12 is not limited to aluminum nitride, and may be, for example, other ceramic materials such as alumina, various resin materials, various composite materials, and the like.

The plurality of high-temperature-side electrodes 14 are patterned on the lower surface of the high-temperature-side substrate 11 in the Z-axis direction. Each high-temperature-side electrode 14 electrically connects the P-type element 13a and N-type element 13b pair constituting each thermoelectric element pair 13. In the example shown in FIG. 2, 12 high-temperature-side electrodes 14 are provided in order to form 12 thermoelectric element pairs 13.

The plurality of low-temperature-side electrodes 15 are patterned on the upper surface of the low-temperature-side substrate 12 in the Z-axis direction. Each low-temperature-side electrode 15 connects a plurality of thermoelectric element pairs 13 in series by connecting the P-type element 13a and the N-type element 13b. In this way, in the thermoelectric power generating module 10, the P-type elements 13a and the N-type elements 13b are alternately connected in series.

The high temperature side electrodes 14 and the low-temperature-side electrodes 15 can be formed of, for example, a metal material such as gold, nickel, or tin. The high-temperature-side electrodes 14 and the low-temperature-side electrodes 15 are configured, for example, as a plating film formed by performing a plating process on the high-temperature-side substrate 11 and the low-temperature-side substrate 12. In this case, the plating film may be a single layer film or a multilayer film.

The P-type elements 13a and the N-type elements 13b respectively constituting the plurality of thermoelectric element pairs 13 are soldered to the high-temperature-side electrode 14 and the low-temperature-side electrode 15. Besides solder, it is possible to use a brazing material or metal paste for bonding the P-type elements 13a and the N-type elements 13b to the high-temperature-side electrode 14 and the low-temperature-side electrode 15.

FIG. 3 is a plan view schematically showing a schematic configuration of the thermoelectric power generating device 100. The above-mentioned electrical storage portion 40, the voltage measuring portion 50, and the temperature detecting portion 60 are shown in FIG. 3, with the positions of the low-temperature-side electrodes 15 being shown with broken lines. The thermoelectric power generating module 10 is further provided with a pair of first extraction electrodes 16, a pair of first lead wires 17, a pair of second extraction electrodes 18, and a pair of second lead wires 19.

The pair of first extraction electrodes 16 are respectively provided on two low-temperature-side electrodes 15 corresponding to both ends of the series connection of the plurality of thermoelectric element pairs 13, and are drawn outward in the X-axis direction. On the low-temperature side electrodes 15 provided with the respective first lead-out electrodes 16, only one of the P-type elements 13a and the N-type elements 13b are respectively connected to the inside of the first lead-out electrode 16 in the X-axis direction.

The pair of first lead wires 17 are respectively joined to the pair of first extraction electrodes 16 by solder or the like. The first extraction electrodes 16 extend outward in the X-axis direction on the low-temperature-side substrate 12 beyond the opposing region of the high-temperature-side substrate 11. Therefore, since the high-temperature-side substrate 11 is not present on the first extraction electrodes 16, the bonding of each first lead wire 17 to each first extraction electrode 16 is facilitated.

In the thermoelectric power generating module 10, the pair of first extraction electrodes 16 are provided not on the high-temperature-side substrate 11 but rather on the low-temperature-side substrate 12. Therefore, the first lead wires 17 connected to the first extraction electrodes 16 are not easily affected by temperature rise of the high-temperature-side substrate 11. For this reason, in the thermoelectric power generating module 10, the connections between the first extraction electrodes 16 and the first lead wires 17 are favorably maintained.

The pair of first lead wires 17 connect the thermoelectric power generating module 10 to the electrical storage portion 40. Thereby, in the thermoelectric power generating module 10, it is possible to store electrical energy corresponding to the temperature difference between the high-temperature-side electrodes 14 and the low-temperature-side electrodes 15 in the electrical storage portion 40 via the first extraction electrodes 16 and the first lead wires 17.

Accordingly, the thermoelectric element pairs 13 connected in series to the pair of first extraction electrodes 16 can be referred to as a power generating circuit.

The pair of second extraction electrodes 18 are drawn outward in the Y-axis direction from low temperature side electrodes 15 respectively connected to the P-type element 13a and the N-type element 13b of one pair of thermoelectric elements 13. The second extraction electrodes 18 are integrally formed with the low-temperature-side electrodes 15, being typically configured as a series of films plated on the low-temperature-side electrodes 15.

The pair of second lead wires 19 are respectively joined to the pair of second extraction electrodes 18 by solder or the like. The second extraction electrodes 18 extend outward in the Y-axis direction on the low-temperature-side substrate 12 beyond the opposing region of the high-temperature-side substrate 11. Accordingly, since the high-temperature-side substrate 11 is not present on the second extraction electrodes 18, the bonding of each second lead wire 19 to the second extraction electrode 18 is facilitated.

In the thermoelectric power generating module 10, the pair of second extraction electrodes 18 are provided not on the high-temperature-side substrate 11 but rather on the low-temperature-side substrate 12. Therefore, the second lead wires 19 connected to the second extraction electrodes 18 are not easily affected by temperature rise of the high-temperature-side substrate 11. For this reason, in the thermoelectric power generating module 10, the connections between the second extraction electrodes 18 and the second lead wires 19 are favorably maintained.

The pair of second lead wires 19 have a function of connecting the thermoelectric power generating module 10 to the voltage measuring portion 50. The voltage measuring portion 50 is configured to be able to measure the voltage between the pair of second lead wires 19. Accordingly, a thermo-electromotive force V generated by the thermoelectric element pair 13 connected to the pair of second extraction electrodes 18 can be obtained by the voltage measuring portion 50.

When using the thermo-electromotive force V generated by the thermoelectric element pair 13, a temperature difference ΔT between the connection portion with the high-temperature-side electrode 14 and the connection portion with the low-temperature-side electrode 15 in the thermoelectric element pair 13 can be calculated by Equation (1).

$$\Delta T = V/(\alpha_P - \alpha_N) \qquad (1)$$

Here, $\alpha_P$ is the Seebeck coefficient of the P-type element 13a, and $\alpha_N$ is the Seebeck coefficient of the N-type element 13b. The Seebeck coefficients $\alpha_P$ and $\alpha_N$ are average values in a temperature range corresponding to the temperature difference ΔT, and can be calculated from the temperature characteristics of the Seebeck coefficients in the P-type element 13a and the N-type element 13b.

Since the metal material forming the high-temperature-side electrodes 14 and the low-temperature side-electrodes 15 has high thermal conductivity, the temperature difference between the high-temperature-side electrodes 14 and the high-temperature-side substrate 11 and temperature difference between the low-temperature side-electrodes 15 and the low-temperature-side substrate 12 can be substantially ignored. That is, it is possible to treat the temperature difference between the high-temperature-side substrate 11 and the low-temperature-side substrate 12 as ΔT.

In this way, in the thermoelectric power generating module 10, the temperature difference ΔT between the high-temperature-side substrate 11 and the low-temperature-side substrate 12 in the region where the thermoelectric element pairs 13 are disposed is obtained. Accordingly, the thermoelectric element pair 13 connected to the pair of second extraction electrodes 18 can be called a temperature measuring circuit. In addition, the temperature detecting portion 60 is typically configured to be able to detect a temperature $T_L$ of the low-temperature-side substrate 12 of the thermoelectric power generating module 10 by a known method.

Using the temperature difference ΔT between the high-temperature-side substrate 11 and the low-temperature-side substrate 12 in the region where the thermoelectric element pairs 13 are disposed and the temperature $T_L$ of the low-temperature-side substrate 12, a temperature $T_H$ of the high-temperature-side substrate 11 can be calculated by the following Equation (2).

$$T_H = T_L + \Delta T \qquad (2)$$

In this way, in the thermoelectric power generating module 10, the temperature $T_L$ of the low-temperature-side substrate 12 can be converted to the temperature $T_H$ of the high-temperature-side substrate 11 by measuring the voltage of the temperature measuring circuit between the pair of second lead wires 19. That is, in the thermoelectric power generating module 10, the temperature $T_H$ of the high-temperature-side substrate 11 can be ascertained without direct measurement.

Therefore, in the thermoelectric power generating module 10, there is no need to provide the high-temperature-side substrate 11 with a configuration such as a temperature measuring element for measuring the temperature $T_H$ of the high-temperature-side substrate 11. Further, the temperature measuring circuit constituted by the thermoelectric element pair 13 connected to the pair of second extraction electrodes 18 is included in the power generating circuit constituted by the thermoelectric element pair 13 connected to the pair of first extraction electrodes 16. For that reason, all the thermoelectric element pairs 13 provided on the substrates 11 and 12 can contribute to power generation, and so the heat collection efficiency in the high-temperature-side substrate 11 is not impaired. That is, in the thermoelectric power generating module 10, the temperature $T_H$ of the high-temperature-side substrate 11 can be ascertained without impairing the heat collection efficiency.

3. Configuration example of thermoelectric power generating device 100

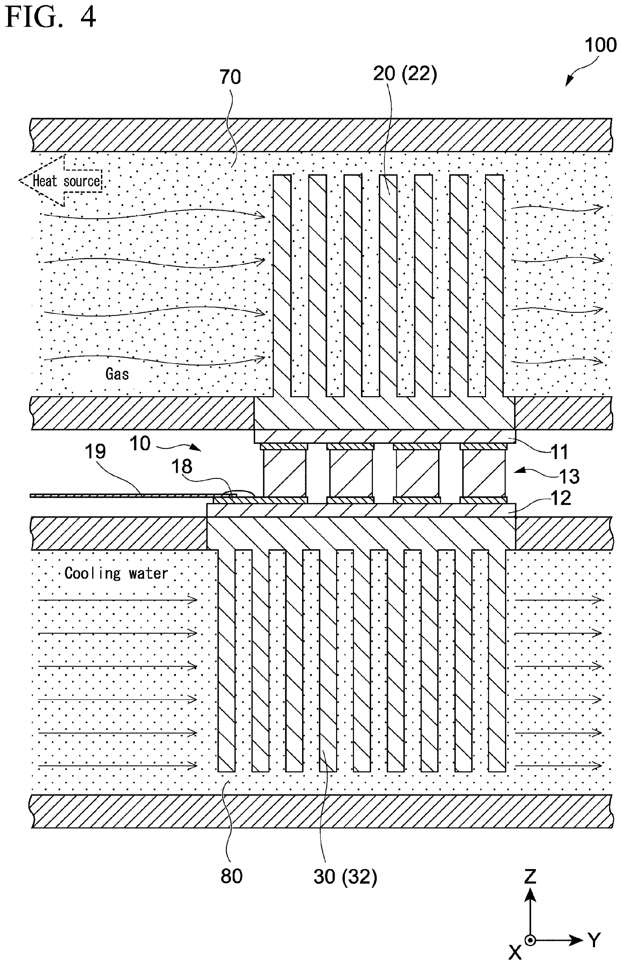

FIG. 4 is a cross-sectional view taken along the line A-A' of FIG. 1 showing a configuration example of the thermoelectric power generating device 100. That is, FIG. 4 shows a cross section parallel to the YZ plane passing through the second extraction electrode 18 and the second lead wire 19 in the thermoelectric power generating device 100. The thermoelectric power generating device 100 further includes a high-temperature-side flow passage 70 and a low-temperature-side flow passage 80 in addition to the above configuration.

The heat collecting fins 22 of the heat collector 20 are arranged in the high-temperature side flow passage 70. In the high-temperature-side flow passage 70, heat generated by a heat source with a gas as a medium is sent to the heat collector 20 by an air blowing mechanism such as a fan. In the example shown in FIG. 4, the high-temperature-side flow passage 70 is connected to the heat source in the region on the left side of the heat collector 20, and an air flow from the left to the right is generated in the high-temperature-side flow passage 70.

Thereby, the heat generated by the heat source can be collected by the heat collecting fins 22 of the heat collector 20. The heat collected by the heat collector 20 is supplied to the high-temperature-side substrate 11 of the thermoelectric power generating module 10 through the heat diffusion plate 21. Thus, in the thermoelectric power generating device 100, the temperature of the high-temperature-side substrate 11 of the thermoelectric power generating module 10 can be raised.

The thermoelectric power generating device 100 is applicable to any heat source, and the heat source connected to the high-temperature-side flow passage 70 is not limited to a specific one. Other heat sources include for example waste heat from automobiles and motorcycles (exhaust gas and the like), waste heat from factories (chemical, steel, machinery and the like), and waste heat from other power generation (thermal power generation, nuclear power generation and the like).

The heat dissipating fins 32 of the radiator 30 are disposed in the low-temperature-side flow passage 80. In the low-temperature-side flow passage 80, cooling water cooled by a cooler or the like is circulated by a pump or the like. Thereby, the heat dissipating fins 32 of the radiator 30 are cooled by the cooling water, and so the radiator 30 and the low-temperature-side substrate 12 are substantially maintained at the temperature of the cooling water.

In the thermoelectric power generating device 100 of this configuration, the temperature detecting portion 60 can be configured as a water temperature gauge capable of detecting the temperature of the cooling water circulating in the low-temperature-side flow passage 80. That is, in this configuration, the temperature of the cooling water detected by the temperature detecting portion 60 can be made the temperature $T_L$ of the low-temperature-side substrate 12.

The temperature detecting portion 60 is not limited to the aforementioned constitution provided the temperature detecting portion 60 is capable of detecting the temperature $T_L$ of the low-temperature-side substrate 12. For example, the temperature detecting portion 60 may be configured to be able to directly detect the temperature of the low-temperature-side substrate 12 or the radiator 30. A temperature sensor such as a thermocouple or a thermistor can be used to detect the temperature of the low-temperature-side substrate 12 or the radiator 30.

Moreover, the temperature detected by the temperature detecting portion 60 is not limited to the temperature $T_L$ of the low-temperature-side substrate 12. For example, the temperature detecting portion 60 may be configured to be able to detect the average temperature $T_{AVE}$ of the thermoelectric element pair 13. In this case, for example, the temperature detecting portion 60 can be configured to be able to measure the electrical resistivity $\rho$ between the second lead wires 19.

The electrical resistivity $\rho$ is obtained as an average value of the electrical resistivity between the second lead wires 19 in the temperature range corresponding to the temperature difference $\Delta T$. Therefore, using the temperature characteristics of the electrical resistivity of the P-type element 13a and the N-type element 13b, it is possible to calculate the average temperature $T_{AVE}$ of the thermoelectric element pair 13 connected to the second lead wires 19 from the electrical resistivity $\rho$.

As described above, the temperature difference between the high-temperature-side electrodes 14 and the high-temperature-side substrate 11 and the temperature difference between the low-temperature-side electrodes 15 and the low-temperature-side substrate 12 can be substantially ignored. For this reason, it is possible to treat the average temperature $T_{AVE}$ of the thermoelectric element pairs 13 as the average temperature between the high-temperature-side substrate 14 and the low-temperature-side substrate 15.

Accordingly, assuming that the thermal conductivity in the Z-axis direction of P-type element 13a and N-type element 13b is uniform, using the temperature difference $\Delta T$ and the average temperature $T_{AVE}$ of the thermoelectric element pair 13, it is possible to calculate the temperature $T_H$ of the high-temperature-side substrate 11 by the following equation (3).

$$T_H = T_{AVE} + \Delta T/2 \qquad (3)$$

In this way, the temperature $T_H$ of the high-temperature-side substrate 11 can be calculated without using the temperature $T_L$ of the low-temperature-side substrate 12 by detecting the average temperature $T_{AVE}$ of the thermoelectric element pair 13 by the temperature detecting portion 60. Note that the temperature detecting portion 60 may measure the electrical resistivity $\rho$ between the first lead wires 17 instead of the electrical resistivity $\rho$ between the second lead wires 19.

In the thermoelectric power generating device 100, the temperature rises more easily in a portion closer to the heat source of the heat collector 20, that is, a portion disposed on the upstream side in the high-temperature-side flow passage 70. Therefore, in the high-temperature-side substrate 11 of the thermoelectric power generating module 10, the temperature rises more easily in a region closer to the heat source. For this reason, in the thermoelectric power generating module 10, damage to the thermoelectric element pairs 13, which is a cause of failure, easily occurs in the region on the heat source side.

Therefore, in the thermoelectric power generating device 100, failure of the thermoelectric power generating module 10 can be effectively prevented by performing management so that the temperature $T_H$ of the region on the heat source side in the high-temperature-side substrate 11 does not become too high. For this reason, in the thermoelectric power generating module 10, it is preferable that the second extraction electrodes 18 be drawn out from the low-temperature-side electrodes 15 disposed on the heat source side.

With this configuration, in the thermoelectric power generating device 100, the thermo-electromotive force V generated by the thermoelectric element pair 13 disposed on the heat source side is obtained by the voltage measuring portion 50. For this reason, in the thermoelectric power generating device 100, it is possible to accurately ascertain the temperature $T_H$ of the region on the heat source side of the high-temperature-side substrate 11 where temperature rise easily occurs.

For example, in the thermoelectric power generating device 100, the temperature $T_H$ of the region on the heat source side of the high-temperature-side substrate 11 can be monitored, and the air blowing in the high-temperature-side flow passage 70 can be stopped when the temperature $T_H$ exceeds a predetermined threshold. Thereby, since it is possible to suppress a further temperature rise of the region on the heat source side of the high-temperature-side substrate 11, failure of the thermoelectric power generating module 10 can be effectively prevented.

4. Modification of thermoelectric power generating module 10

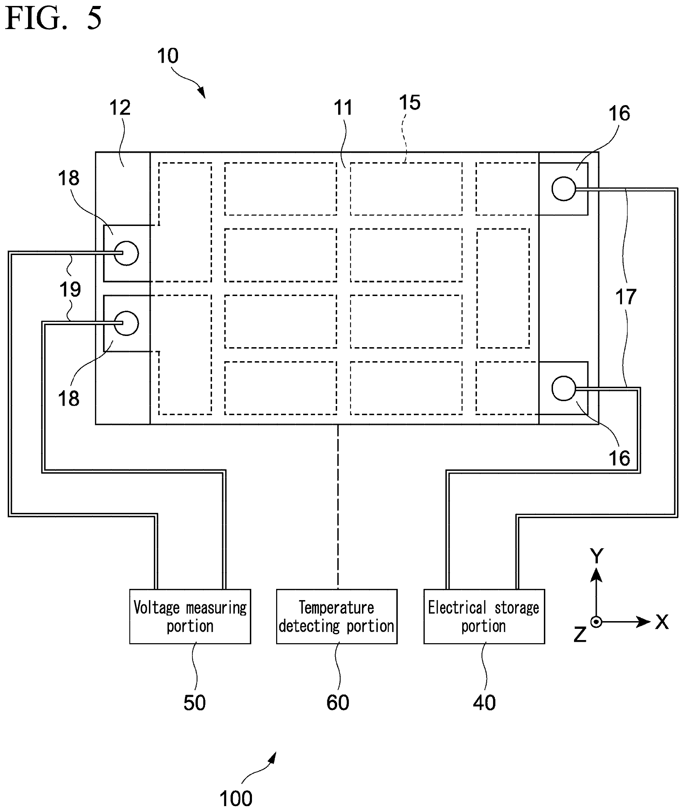

The positions of the second extraction electrodes 18 in the thermoelectric power generating module 10 can be determined in accordance with the position of the heat source or the like. For example, as shown in FIG. 5, the second extraction electrodes 18 may be drawn out in the X-axis direction from the low-temperature side electrodes 15 disposed at the end portion in the X-axis direction opposite the low-temperature-side electrodes 15 on which the first extraction electrodes 16 are disposed.

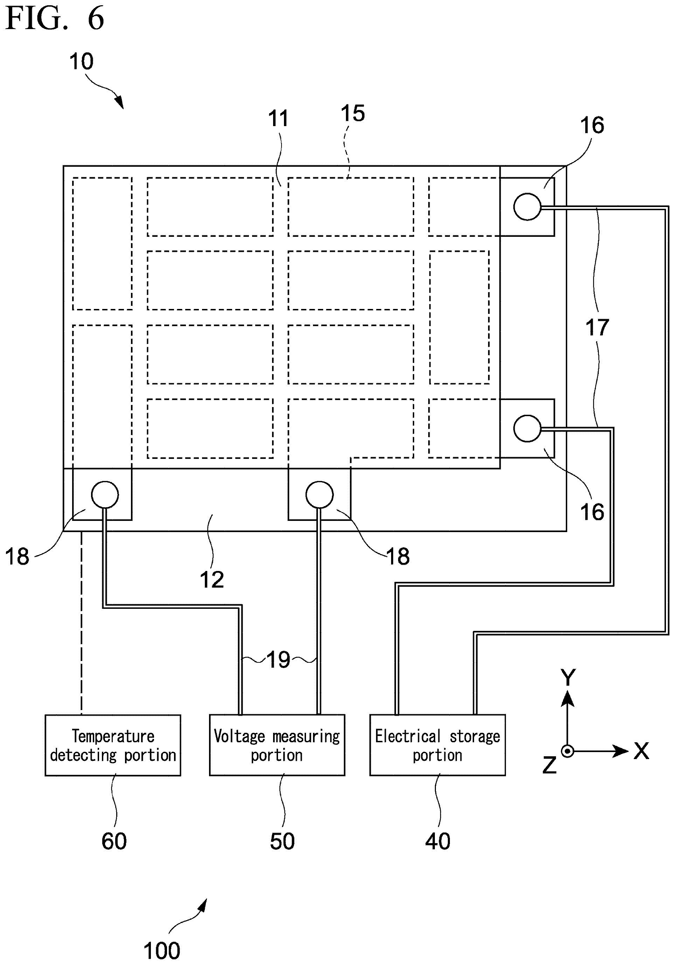

Further, as shown in FIG. 6, the second extraction electrodes 18 may be configured to be able to measure the thermo-electromotive force V generated by the plurality of thermoelectric element pairs 13. Using the thermo-electromotive force V generated by n thermoelectric element pairs 13, the temperature difference ΔT can be calculated by the following Equation (4).

$$\Delta T = V/n\ (\alpha_P - \alpha_N) \qquad (4)$$

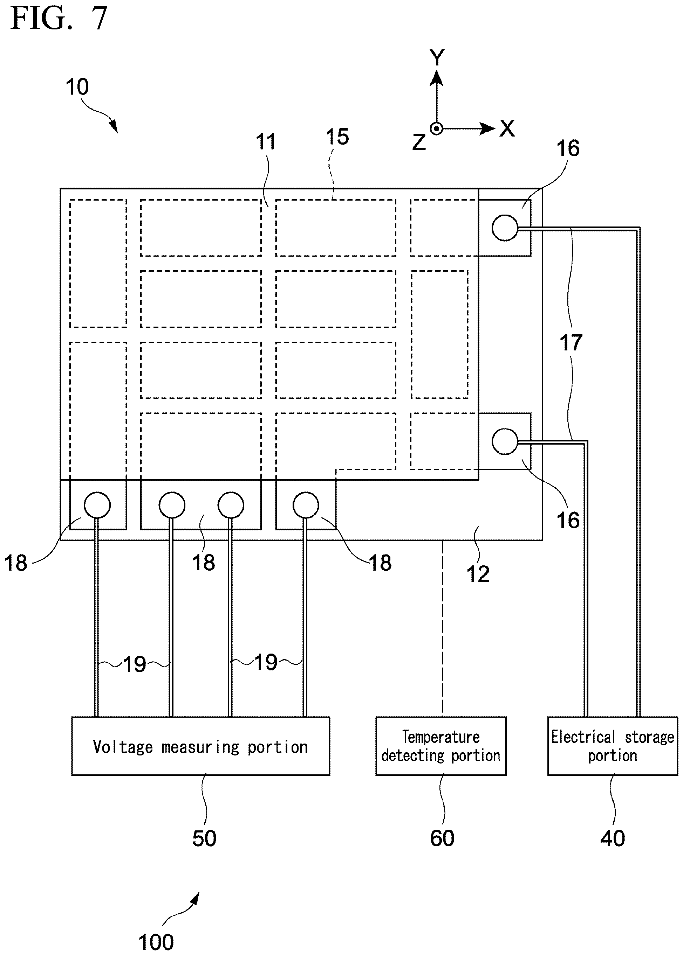

Furthermore, as shown in FIG. 7, the thermoelectric power generating module 10 may be provided with multiple pairs of second extraction electrodes 18. Thereby, since the thermo-electromotive force V generated by the plurality of thermoelectric element pairs 13 can be individually measured by the voltage measuring portion 50, the temperature $T_H$ of multiple regions in the high-temperature-side substrate 11 can be ascertained.

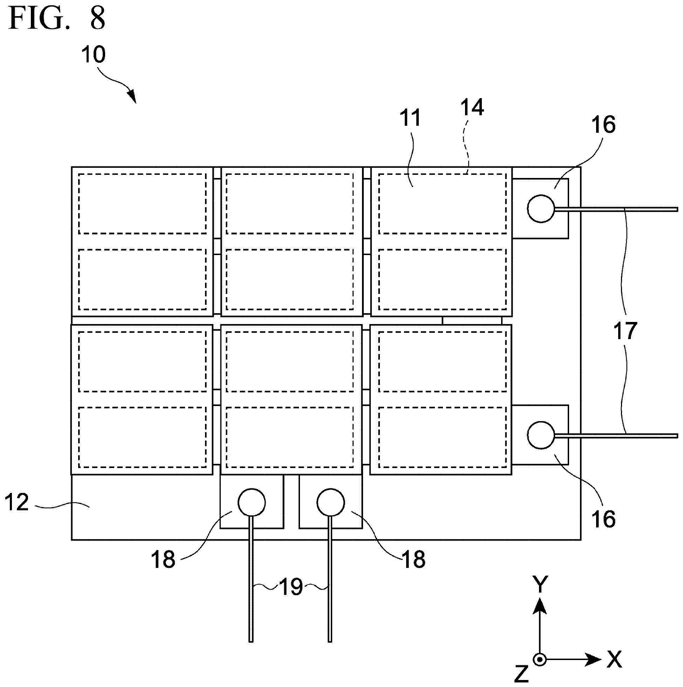

In addition, as shown in FIG. 8, the high-temperature-side substrate 11 may be divided into a plurality. Thereby, it is possible to suppress errors in the measurement of the temperature $T_H$ of the high-temperature-side substrate 11 due to the influence of heat transfer along the XY plane in the high-temperature-side substrate 11. In addition, the manner of dividing the high-temperature-side substrate 11 can be variously changed according to the pattern of the-high temperature-side electrodes 14 shown by the broken lines in FIG. 8.

As shown in FIG. 8, when the high-temperature-side substrate 11 is divided into a plurality, in the divided high-temperature-side substrate, since heat diffusion and heat inflow of the high-temperature-side substrate at the portion where the temperature measuring circuit is arranged are suppressed, it is possible to more accurately measure the temperature of the high-temperature-side substrate at the portion where the temperature measuring circuit is disposed.

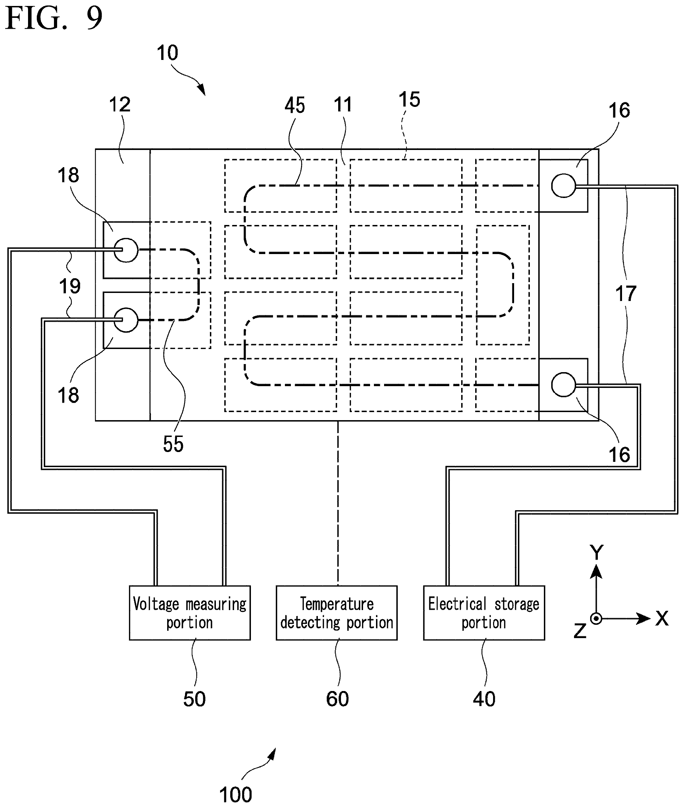

Furthermore, as shown in FIG. 9, a temperature measuring circuit 55 configured by the thermoelectric element pair 13 connected to the pair of second extraction electrodes 18, and a power generating circuit 45 configured by the thermoelectric element pair 13 connected in series to the pair of first extraction electrodes 16 may be independently provided. That is, the temperature measuring circuit 55 may be disposed electrically in parallel with the power generating circuit 45 constituted by the thermoelectric element pair 13 connected in series to the pair of first extraction electrodes 16. By providing the temperature measuring circuit 55 independently in this manner, the temperature measurement accuracy of the portion where the temperature measuring circuit is disposed can be further improved as compared with the case where the temperature measuring circuit is included in the power generating circuit.

Furthermore, the temperature measuring circuit 55 may be made independent of the power generating circuit 45, and the high-temperature-side substrate 11 may be divided as shown in FIG. 8. In this case, by arranging the temperature measuring circuit 55 on a substrate portion where high temperature measurement accuracy is particularly required among the divided high-temperature-side substrates, the temperature of each divided high-temperature-side substrate can be individually and precisely measured.

5. Other embodiments

While exemplary embodiments of the present invention have been described above, the present invention is not limited to the aforementioned embodiments. It is a matter of course that various changes can be made within the scope of not departing from the gist of the present invention.

For example, the thermoelectric power generating device 100 may be provided with a plurality of thermoelectric power generating modules 10. Further, in the thermoelectric power generating device 100, at least one of the heat collector 20, the radiator 30, the electrical storage portion 40, the voltage measuring portion 50, the temperature detecting portion 60, the high-temperature-side flow passage 70, and the low-temperature-side flow passage 80 may be configured to be connectable as an external constitution.

According to the embodiment of the present invention described above, it is possible to prevent failure due to overheating of the high-temperature-side substrate without impairing the heat collection efficiency of the thermoelectric power generating module. Therefore, it is possible to provide a thermoelectric power generating module capable of preventing failure due to overheating, a thermoelectric power generating device using the thermoelectric power generating module, and a temperature measuring method.

Reference Symbols

10: Thermoelectric power generating module
11: High-temperature-side substrate
12: Low-temperature-side substrate
13: Thermoelectric element pair
14: High-temperature-side electrode
15: Low-temperature-side electrode
16: First extraction electrode
17: First lead wire
18: Second extraction electrode
19: Second lead wire
20: Heat collector
30: Radiator
40: Electrical storage portion
50: Voltage measuring portion
60: Temperature detecting portion
100: Thermoelectric power generating device

**Claims**

1. A thermoelectric power generating module comprising:

a high-temperature-side substrate;
a low-temperature-side substrate that faces opposite the high-temperature-side substrate;
a plurality of thermoelectric element pairs that are configured from mutually adjacent P-type elements and N-type elements, and are arrayed between the high-temperature-side substrate and the low-temperature-side substrate;
a plurality of high-temperature-side electrodes that are provided on the high-temperature-side substrate and connect the pairs of the P-type elements and the N-type elements that respectively constitute the plurality of thermoelectric element pairs;
a plurality of low-temperature-side electrodes that are provided on the low-temperature-side substrate, and by connecting the P-type elements and the N-type elements, connect the plurality of thermoelectric element pairs;
a pair of first extraction electrodes that are connected to both ends of the plurality of low-temperature-side electrodes that connect in series the plurality of thermoelectric element pairs; and
a pair of second extraction electrodes that are connected to a portion of the thermoelectric element pairs among the plurality of thermoelectric element pairs via the low-temperature-side electrodes.

2. The thermoelectric power generating module according to claim 1, wherein the second extraction electrodes are connected to a portion of the thermoelectric element pairs among the plurality of thermoelectric element pairs connected in series.

3. The thermoelectric power generating module according to claim 2, wherein the second extraction electrodes are connected midway in the series connection of the plurality of thermoelectric element pairs.

4. The thermoelectric power generating module according to claim 1, wherein the second extraction electrodes are connected to a temperature measuring circuit that includes a plurality of the thermoelectric element pairs separate from the plurality of thermoelectric element pairs connected in series.

5. The thermoelectric power generating module according to any one of claims 1 to 4, wherein the high-temperature-side substrate is divided into a plurality.

6. The thermoelectric power generating module according to any one of claims 1 to 5, wherein the second extraction electrodes extend outward on the low-temperature-side substrate beyond the opposing region of the high-temperature-side substrate.

7. The thermoelectric power generating module according to any one of claims 1 to 6, wherein the second extraction electrodes are connected to the low-temperature-side electrodes disposed on a heat source side among the plurality of low-temperature-side electrodes.

8. A thermoelectric power generating device comprising:

the thermoelectric power generating module according to any one of claims 1 to 7; and
a voltage measuring portion that measures a voltage between the second extraction electrodes.

9. The thermoelectric power generating device according to claim 8, further comprising a temperature detecting portion that detects a temperature of the low-temperature-side substrate.

10. A temperature measuring method for a high-temperature-side substrate in a thermoelectric power generating module comprising a plurality of thermoelectric element pairs, high-temperature-side electrodes and low-temperature-side electrodes that connect the plurality of thermoelectric element pairs, and the high-temperature side substrate and a low-temperature side substrate respectively comprising the high-temperature-side electrodes and low-temperature-side electrodes, wherein the temperature measuring method comprises the steps of:

measuring a voltage between at least one thermoelectric element pair among the plurality of thermoelectric element pairs;

calculating a temperature difference between the high-temperature-side substrate and the low-temperature-side substrate from the voltage; and

calculating the temperature of the high-temperature-side substrate using the temperature difference.

11. The temperature measuring method according to claim 10, wherein the temperature measuring method comprises the steps of:

measuring electrical resistance between at least one thermoelectric element pair among the plurality of thermoelectric element pairs;

calculating an average temperature between the high-temperature-side substrate and the low-temperature-side substrate from the electrical resistance; and

calculating the temperature of the high-temperature-side substrate using the temperature difference and the average temperature.

# FIG. 1

FIG. 2

# FIG. 3

10

11    15    16

12

16

17

18    18

19

| Temperature detecting portion | Voltage measuring portion | Electrical storage portion |

60    50    40

Y
Z⊙ → X

100

# FIG. 4

# FIG. 5

| Voltage measuring portion | Temperature detecting portion | Electrical storage portion |

50    60    40

100

FIG. 6

| Temperature detecting portion | Voltage measuring portion | Electrical storage portion |

60      50      40

100

FIG. 7

Voltage measuring portion

Temperature detecting portion

Electrical storage portion

FIG. 8

FIG. 9

Voltage measuring portion

50

Temperature detecting portion

60

Electrical storage portion

40

100

**INTERNATIONAL SEARCH REPORT**

| International application No. |
|---|
| PCT/JP2018/011448 |

**A. CLASSIFICATION OF SUBJECT MATTER**
Int.Cl. H01L35/30(2006.01)i, G01K3/08(2006.01)i, H01L35/10(2006.01)i,
H01L35/32(2006.01)i, H02N11/00(2006.01)i

According to International Patent Classification (IPC) or to both national classification and IPC

**B. FIELDS SEARCHED**

Minimum documentation searched (classification system followed by classification symbols)
Int.Cl. H01L35/30, G01K3/08, H01L35/10, H01L35/32, H02N11/00

| Documentation searched other than minimum documentation to the extent that such documents are included in the fields searched | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2005-117835 A (TOYOTA MOTOR CORP.) 28 April 2005,<br>paragraphs [0001], [0006], [0012]–[0028], fig. 1–8 (Family:<br>none) | 1–3<br>1–3, 5–11<br>4 |
| Y | JP 2008-244100 A (YAMAHA CORP.) 09 October 2008, paragraphs<br>[0001], [0020]–[0027], fig. 1 (Family: none) | 1–3, 5–11 |
| X<br>A | JP 2015-138949 A (KYOCERA CORP.) 30 July 2015, paragraphs<br>[0001], [0016]–[0035], fig. 1–3 (Family: none) | 1–3, 6<br>4–5, 7–11 |
| X<br>A | JP 3-181185 A (NIPPON INTER ELECTRONICS CORP.) 07 August<br>1991, page 1, lower left column, lines 12–17, page 2, upper<br>left column, line 13 to upper right column, line 20, fig. 1<br>(Family: none) | 1–2, 5<br>3–4, 6–11 |
| A | JP 10-270762 A (S I I R D CENTER KK) 09 October 1998, entire<br>text, all drawings & US 6084172 A | 1–11 |

| ☐ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21 May 2018 (21.05.2018) | 29 May 2018 (29.05.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**REFERENCES CITED IN THE DESCRIPTION**

**Patent documents cited in the description**

- JP 2017058694 A

- JP 2009094130 A